Europäisches Patentamt

European Patent Office

Office européen des brevets

(11) Publication number: **0 081 917**
**B1**

(12) **EUROPEAN PATENT SPECIFICATION**

(45) Date of publication of patent specification: **11.06.86**

(21) Application number: **82306098.3**

(22) Date of filing: **16.11.82**

(51) Int. Cl.⁴: **H 03 K 17/62**, H 03 K 17/693,
H 03 K 19/173, G 06 F 9/22

(54) **Programmable multiplexer.**

(30) Priority: **18.11.81 US 322462**

(43) Date of publication of application:
**22.06.83 Bulletin 83/25**

(45) Publication of the grant of the patent:
**11.06.86 Bulletin 86/24**

(84) Designated Contracting States:
**BE DE FR GB IT NL SE**

(56) References cited:
**US-A-4 121 055**

**ELECTRONIC ENGINEERING, vol. 52, no. 633,
January 1980, T.L. LARSON et al. "Field
programmble logic devices", pages 37, 39, 41,
43, 45, 57, 49-50, 52, 54**

**ELECTRONICS, vol. 51, no. 10, May 1978, D.
WYLAND "Managing the flow of data is easy
with programmable multiplexer", pages 132-
135**

(73) Proprietor: **BURROUGHS CORPORATION (a
Michigan corporation)
Burroughs Place
Detroit, Michigan 48232 (US)**

(72) Inventor: **Woodward, Thomas Ralph
103 Valley Drive
West Chester Pennsylvania 19380 (US)**

(74) Representative: **Kirby, Harold Douglas Benson
et al
Marlborough Lodge 14 Farncombe Road
Worthing West Sussex BN11 2BT (GB)**

Courier Press, Leamington Spa, England.

## Description

Background of the Invention

This invention relates to the architecture of a particular type of digital logic circuit called a programmable multiplexer.

In general, practically all digital logic circuits are packaged on semiconductor chips in accordance with the particular function that they perform. See, for example, *The TTL Data Book for Design Engineers,* 2nd Edition, Texas Instruments, Section 1 page 9 wherein several logic circuit chips are listed according to their function, and in particular note the "data selector-multiplexer" chips since they relate directly to the subject of this invention.

Each data selector-multiplexer chip there listed contains one or more fixed multiplexer circuit which is herein defined as a circuit having a plurality of data inputs, a plurality of control inputs, and an output. In operation, control signals are applied to the control inputs, and in response the fixed multiplexer circuit selectively passes a signal from one of the data inputs to the output. In other words, the data inputs are multiplexed to the output in response to the control signals in a fixed predetermined fashion.

Typically, several fixed multiplexer circuits are fabricated on a single chip. See, for example, the Texas Instruments chips 54LS253 and 74LS253 in Section 7, page 369 of the above-cited reference. These chips contain two such circuits, each of which has four data inputs and one output; and the data inputs on both of those circuits are selected by control signals that are common to both circuits.

One significant limitation, however, to these 54LS253 and 74LS253 chips and other similar prior art chips containing several fixed multiplexer circuits is that they are too inflexible. More specifically, the data inputs which the several fixed multiplexer circuits select in response to the control signals cannot be picked in any desired combination. Instead, the data inputs which pass to the outputs in response to the control signals are fixed. Typically, in response to control signals encoded as a "binary one", all of the fixed multiplexer circuits select their "first" data input; in response to control signals encoded as a "binary two", all of the fixed multiplexer circuits select their "second" data input; etc.

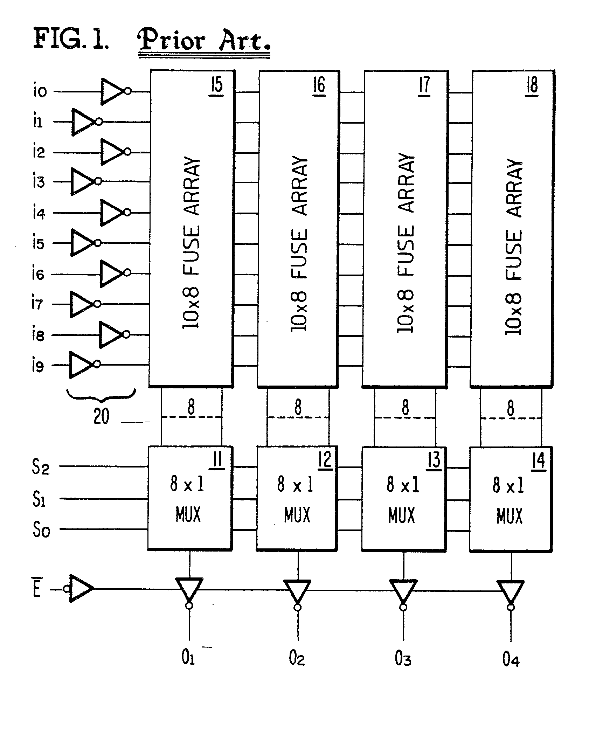

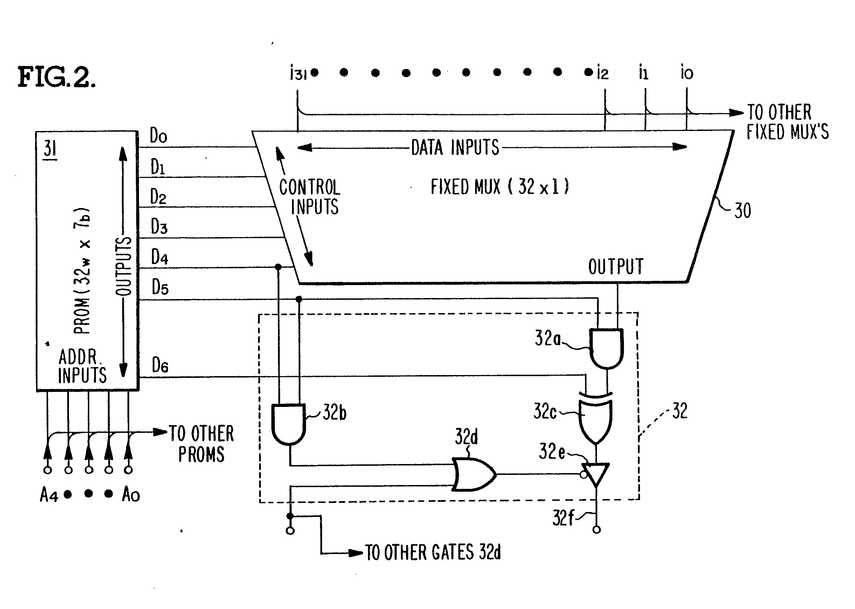

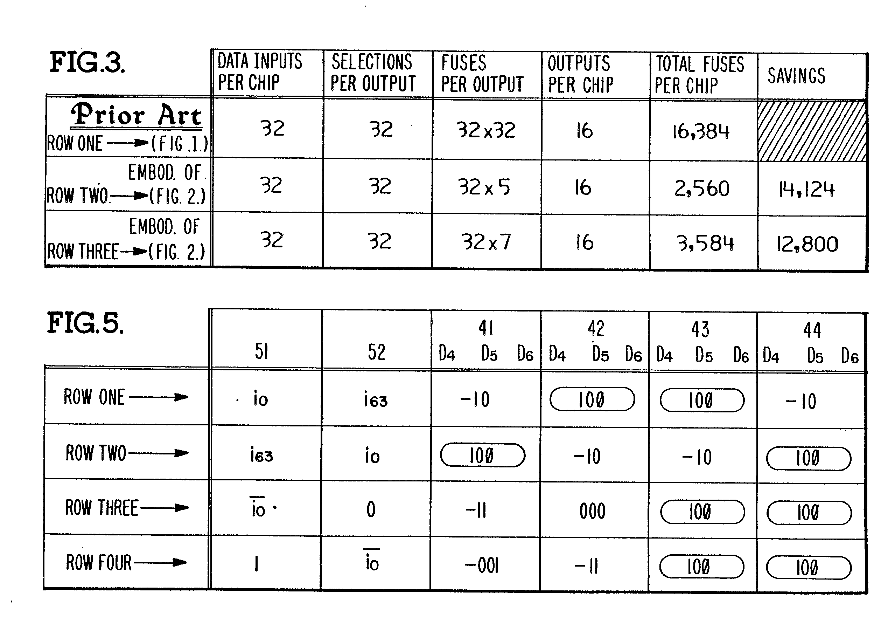

To overcome this problem, a "programmable multiplexer" chip has been recently introduced into the market by a company called Monolithic Memories. This programmable multiplexer chip has a part number 29693, and its block diagram is illustrated in Figure 1.

As there illustrated, this programmable multiplexer is comprised of four fixed multiplexer circuits 11—14 and a corresponding number of fusible link arrays 15—18. In operation, input signals $i_0$—$i_9$ are received on the chip by buffers 20; and their outputs are sent to the fusible link arrays. Outputs from the fusible link arrays 15—18 are then sent to the fixed multiplexer circuits 11—14 respectively.

Circuits 11—14 pass their inputs to their output in a fixed predetermined fashion in response to a common set of control signals $S_0$—$S_2$. But this 29693 is much more flexible than the aforementioned Texas Instruments 54LS253 and 74L253 chips because the fuse arrays enable the input signals $i_0$—$i_7$ to be passed to the fixed multiplexer circuits 11—14 in any desired combination.

Suppose, for example, that it is desired to pass inputs $i_7, i_2, i_8$, and $i_0$ through the fixed multiplexer circuits 11,12,13 and 14 respectively in response to $S_0, S_1, S_2$ signals of 001. Assuming that a 001 code selects the first input on each of the fixed multiplexer circuits 11,12,13 and 14, then the above result is achieved by merely blowing the appropriate fuses in arrays 15,16,17 and 18 such that input $i_7$ is sent to the first input of fixed multiplexer circuit 11, input $i_2$ is sent to fixed multiplexer circuit 12, etc.

The prior art multiplexer of Figure 1 is also disclosed in an article in the magazine "Electronic Engineering", Vol. 52, No. 633, January 1980, by T L Larson et al entitled "Field Programmable Logic Devices" on pages 37,39,41,43,45,47,49,50,52 and 54. The prior art shown with Figure 1 of this application is shown in Figure 8 of the magazine article. That article also discloses various forms of logic array. In Figure 1 of that article there is disclosed a field programmable logic array wherein a plurality of input signals are buffered and inverted and fuse programmed as the inputs to a plurality of parallel AND-gates whose outputs are similarly fuse programmed as the inputs to an array of OR-gates to provide a plurality of fuse programmable functions of the input digital signals. By contrast, the present invention seeks to provide improvement over the prior art field programmable logic array (Figures 1 and 2 of the article) by providing for the multiplexed through-passage of selectable input signals or their inverses using a fuse array operating only on the address inputs of multiplexers as opposed to the use of fusible links on the input signal paths, thereby reducing the number of fusible links required in a multiplexing process.

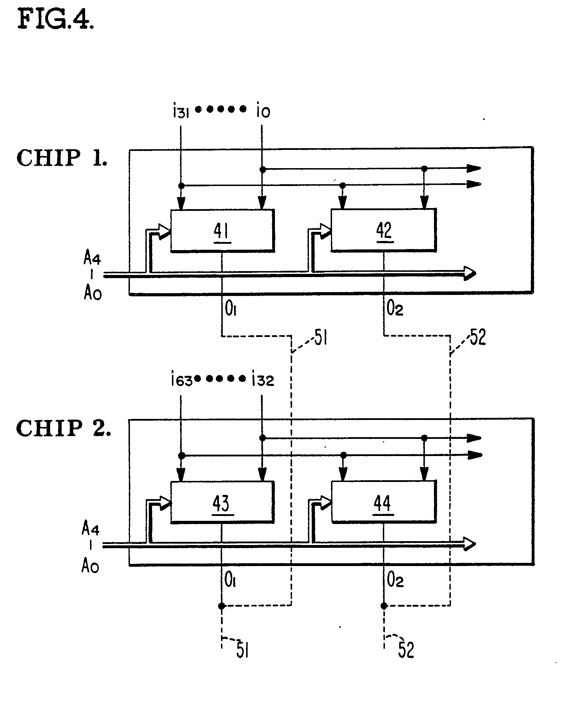

The cited article discloses a field programmable logic sequencer (Figures 3 and 4) wherein all of the elements of the field programmable logic array (Figures 1 and 2) are provided together with flip flops. A first group of flip flops are set and reset according to a first group of selected functions to be fed back as additional next state selecting input signals parallel to the incoming input signals. A second set of flip flops is used being set and reset via the OR-gates to provide a held output function. The prior art field programmable logic sequencer (Figures 3 and 4 of the magazine article) is therefore a selectably fuse programmable state sequence machine exploiting the structure of the field programmable logic array (Figures 1 and 2 of the article). The output of the field programmable logic sequencer is a sequence of output functions run through in response to a sequence of input states. By contrast, the present invention seeks to provide a simple multiplexer wherein a parallel

output word consists in selected bits or their inverses from a parallel input word where the number of fused programmable links is minimised by restricting fuse programming to an address modifier for an array of digital multiplexers there being no fuse programmable links on any of the connections carrying signals from the parallel input word or from the secondary feedback words (P0,P5,C) (Figure 3 and Figure 4 of the cited magazine article). The cited article (Figure 5) shows the field programmable logic array of Figure 1 of the article wherein the connections to the OR-gates from the AND-gates are fixed and are not field programmable by fuse link. The same comparison exists between the prior art field programmable gate array (Figure 5 of the article) and the present invention as exists between the prior art field programmable logic array (Figure 1 of the cited article) and the present invention.

United States Patent 4,121,055 discloses a system wherein a counter provides cyclically sequential addresses to a programmable read-only memory whose output is coupled as input to a multiplexer receiving a plurality of input signals, any one of which at any one time is to be transmitted for example over a telemetry system. The output from the programmable read-only memory is decoded as an address which selects just one of the plurality of input signals for provision to the multiplexer output. The present invention seeks to provide improvement thereover by allowing a plurality of multiplexers, each operative to select one from a plurality of input signals to be operated in parallel rows such that each multiplexer has associated therewith its own individual programmable read-only memory and is operative to provide as its output any selectable one of its inputs and by providing that multiple rows of multiplexers may be provided in parallel whilst in receipt of the same input address word by providing output logic having a selectably high impedance tri-state condition in response to the address word, outputs of a plurality of corresponding multiplexers in a plurality of rows being wired in parallel and the programmable read-only memories being arranged for only one of the multiplexers in one of the rows in that position not to be in the tri-state high output condition.

The drawbacks of the prior art multiplexer system referred to hereinbefore, along with the features and advantages of the present invention, are described in detail in the following detailed description in conjunction with Figures 2—5.

The present invention consist in a programmable multiplexer circuit comprising a multiplexer unit in turn comprising; a multiplexer coupled to receive a plurality of input signals and to receive a plurality of control signals and operable in response to receipt thereof to select one from among said plurality of input signals to be coupled as an output of said multiplexer; and a programmable read-only memory coupled to receive as input a plurality of address signals and operable in response to receipt thereof to provide, as output, said plurality of control signals in accordance with a respective, predetermined programme stored therein; said multiplexer circuit being characterised by comprising a plurality of said multiplexer units; by each of said multiplexer units comprising a logic circuit coupled to receive one or more of said control inputs, coupled to receive said output of said multiplexer, and operable in response thereto selectably to provide as output either a representation of said output of said multiplexer or a high impedance tri-state output; by each of said plurality of multiplexer units being coupled to receive said plurality of address signals; by said plurality of multiplexer units being arranged in one or more groups each comprising two or more multiplexer units where, in each group, said outputs of said logic circuits are wired in parallel; and by said respective predetermined programmes in said read-only memories in each of said multiplexer units in each of said groups being such that in each group at most only one of said multiplexer units in said each group has its respective logic circuit not providing, as its output, said high impedance tri-state output for each particular combination of said address signals.

Accordingly, a primary object of the present invention is to provide an improved programmable multiplexer chip as described in conjunction with Figs. 2—5.

Brief Summary of the Invention

This object is achieved in the present invention by providing a plurality of fixed multiplexer circuits and a corresponding number of programmable memories on a semiconductor chip. Each of the fixed multiplexer circuits includes a plurality of data inputs, a plurality of control inputs, and an output for passing a signal from any one of the data inputs to the output in a fixed predetermined fashion in response to encoded signals on the control inputs; and each of the memories includes an address input and parallel outputs for generating signals thereon as a programmable transformation of the memory address.

All of the fixed multiplexer circuits have their data inputs intercoupled together such that they receive the same data input signals; all of the memories have their address inputs intercoupled together such that they receive the same address; and the memories also have their outputs respectively coupled to the control inputs of the plurality of fixed multiplexer circuits. Thus, the encoded control signals for the plurality of fixed multiplexers are formed by respective programmable transformations of a memory address, which in turn enables any combination of data inputs to be passed to the fixed multiplexer circuit outputs.

Brief Description of the Drawings

Various features and advantages of the invention will best be understood by reference to the following Detailed Description and accompanying drawings wherein:

Figure 1 is a logic diagram, for comparison purposes, of a programmable multiplexer chip constructed according to the prior art;

Figure 2 is a logic diagram of a programmable multiplexer chip constructed according to one preferred embodiment of the invention;

Figure 3 is a chart which compares the number of fuses that are required to implement the programmable multiplexers of Figures 1 and 2;

Figure 4 is a logic diagram illustrating the expandability of the data inputs of the programmable multiplexer chip of Figure 2; and

Figure 5 is a chart illustrating the operation of the Figure 4 logic diagram.

Detailed Description of the Invention

Referring now to Figure 2, one preferred embodiment of a programmable multiplexer chip constructed according to the invention will be described. This embodiment includes a plurality of identical fixed multiplexers, one of which is shown in Figure 2 as indicated by reference numeral 30. All of the fixed multiplexer circuits have 32 data inputs, five control inputs, and one output; and they all have their data inputs coupled together such that they receive the same data input signals $i_0$—$i_{31}$.

Each of the fixed multiplexer circuits 30 has a separate programmable read-only memory 31 associated with it. Memory 31 contains thirty-two words, each of which is seven bits in length. These words are read from the memory via signals $A_0$—$A_4$ that are applied to the memory's address inputs. All of the memories have their address inputs coupled together to receive the same address signals $A_0$—$A_4$ in parallel.

Also associated with each of the fixed multiplexer circuits 30 and its memory 31 is a separate logic circuit, one of which is indicated by reference numeral 32. Each of these logic circuits includes a pair of AND gates 32a and 32b, an exclusive OR gate 32c, an OR gate 32d, and an output driver 32e. These components are interconnected to their respective fixed multiplexer circuit and memory as illustrated in Figure 2.

In operation, address $A_0$—$A_4$ is sent to all of the memories 30 in parallel. Each of those memories responds by generating output signals $D_0$—$D_6$ as determined by the addressed word. In other words, signals $D_0$—$D_6$ are a programmable transformation of the address. Signals $D_0$—$D_4$ are then sent to the fixed multiplexer circuit 30 to control its output, whereas signals $D_4$—$D_6$ are sent to logic circuit 32 to control that circuit's output.

Suppose, as a specific example, that in response to a particular address, fixed multiplexer circuit 30 is to pass data input $i_2$ to its output. This is achieved by programming the addressed word in memory 31 such that output signals $D_0$—$D_4$ select input $i_2$. For that same memory address, however, the words in the other memories can be encoded differently; and thus any set of data inputs can be sent through the fixed multiplexer circuits in response to a particular memory address.

One important feature of the above-described programmable multiplexer chip is that it not only provides the programmable multiplexing function, but it does this with substantially less circuitry than the prior art required. In particular, the number of fuses which the Figure 2 chip requires is substantially reduced.

This is evident by an inspection of Figure 3 which compares the number of fuses that are required to implement a programmable multiplexer chip having thirty-two data inputs and sixteen outputs via the circuitry of Figures 1 and 2. Calculations for that chip according to the prior art of Figure 1 are made in row 1; whereas calculations for that chip according to Figure 2 are made in row 2.

As indicated in the leftmost column of Figure 3, both embodiments have thirty-two data inputs; and as indicated in the next adjacent column, it is assumed for the purposes of this calculation that there are thirty-two multiplexing functions per output. In other words, it is assumed for the purposes of this comparison that there are five control signals going into each fixed multiplexer circuit. Those control signals have thirty-two combinations which direct each fixed multiplexer circuit to make thirty-two different selections.

Therefore, as shown in the next column, each fuse array in the Figure 1 embodiment will contain $32 \times 32$ fuses. But by comparison, each programmable memory such as memory 31 in the Figure 2 embodiment will only contain $32 \times 5$ fuses. That will provide thirty-two words of five bits each; and each of those five-bit words will pass one data input through the fixed multiplexer circuit.

Again, for the purposes of this comparison, this chip is assumed to have sixteen outputs. Therefore, the total number of fuses per chip in the Figure 1 embodiment will be $32 \times 32 \times 16$ or 16,384; whereas the total number of fuses in the Figure 2 embodiment will only be $32 \times 5 \times 16$ or 2,560. Consequently, with this invention there is a savings of 14,124 fuses!

Also, another important feature of this invention is that the logic circuit 32 in combination with memory 31 provides several additional functions which simply are not obtainable in the prior art. One of these functions is that the inverse of data inputs $i_0$—$i_{31}$ can be selectively transferred to the logic circuit's output 32f. Another of these functions is that a digital "1" or a digital "0" can be selectively sent to output 32f regardless of the state of the multiplexer's data inputs. And still another of these functions is that the number of data inputs that are multiplexed to a particular chip's output can be expanded.

Consider now the details of how these functions are obtained. Firstly, to pass the inverse of a particular data input to output 32f, memory 31 is programmed to· generate signals $D_5$ and $D_6$ as a digital "11". A "1" for signal $D_5$ causes the output of fixed multiplexer 30 to pass through AND gate 32a; and a "1" for signal $D_6$ causes EXCLUSIVE OR gate 32c to invert the output of AND gate 32a. That inverted signal is then sent to output 32f.

Note, by comparison, that a selected data input is sent directly to output 32f in response to signals $D_5$ and $D_6$ from memory 31 being programmed as a '10'. A "1" for signal $D_5$ causes the output of multiplexer 30 to pass through AND gate 32a; and a "O" value for signal $D_6$ causes the output of AND gate 32a to pass directly through EXCLUSIVE OR gate 32c and to output 32f.

Next, to generate a "O" on output 32f regardless of the state of the data inputs $i_0$—$i_{31}$, signals $D_5$ and $D_6$ from memory 31 are programmed as a "00". Signal $D_5$ being a "0' forces the output of AND gate 32a to a "0"; and signal $D_6$ being a "0" causes the "0" output of AND gate 32a to pass directly through EXCLUSIVE OR gate 32c.

Next, to generate a "1" on output 32f, signals $D_5$ and $D_6$ from memory 31 are programmed as a "01". Gate 32a generates a "0" on its output in response to signal $D_5$ being a "0"; and EXCLUSIVE OR gate 32c generates a "1" on its output in response to one of its inputs being "1".

To generate signals $D_5$ and $D_6$ in addition to signals $D_0$—$D_4$ requires two additional fuses per word in memory 31. Thus, as indicated in row 3 of Figure 3, the total number of fuses per output is $32 \times 7$; and the total number of fuses per chip is 3,584. But this is still 12,800 fuses less than the number of fuses required by the prior art circuit of Figure 1.

Next, to understand how the number of data inputs that are multiplexed to a particular chip's output can be increased, reference should be made to Figure 4. In that figure, two identical programmable multiplexer chips which are constructed according to the invention are labeled as "chip 1" and "chip 2". Each of these chips contains all of the Figure 2 circuitry repeated 16 times. Boxes 41, 42, 43 and 44 represent respective copies of that circuitry.

Data input signals $i_0$—$i_{31}$ are sent to circuits 41 and 42 on chip 1 where they are then multiplexed to respective outputs $O_1$ and $O_2$, each of which corresponds to an output 32f. Similarly, data input signals $i_{32}$—$i_{63}$ are sent to circuits 43 and 44 on chip 2 where they are then multiplexed to respective outputs $O_1$ and $O_2$. Outputs $O_1$ and $O_2$ from chips 1 and 2 are then interconnected by conductors 51 and 52.

With this circuit, any of the data input signals $i_0$—$i_{63}$ can be gated in any desired combination onto conductors 51 and 52. Suppose, for example, that it is desired to gate signals $i_0$ and $i_{63}$ onto conductors 51 and 52 respectively. To accomplish this, memory address $A_0$—$A_4$ is programmably transformed as indicated by row 1 in the chart of Figure 5.

That row indicates that the memories 31 in circuits 42 and 43 are programmed to generate output signals $D_4$ and $D_5$ as a "10". This causes AND gate 32b to generate a "1" on its output; that "1" passes through OR gate 32d to driver 32f; and driver 32e must receive a "0" from gate 32d to be enabled. Consequently, driver 32d is disabled, which connects a tri-state high impedance to output 32f.

Since logic circuits 42 and 43 generate no signals on conductors 51 and 52, the signals on those conductors are determined solely by circuits 41 and 44. Consequently, signal $i_0$ is passed to conductor 51 by programming signals $D_0$—$D_4$ in circuit 41 to select input $i_0$ and by programming signals $D_5$ and $D_6$ to a "10". Similarly, signal $i_{63}$ is passed to conductor 52 by generating signals $D_1$—$D_4$ to select input $i_{63}$ and by generating signals $D_5$ and $D_6$ to a "10".

This expandability of the data inputs simply is not possible to obtain with the prior art chip of Figure 1. There, all of the chip's outputs $O_1$—$O_4$ are either enabled or disabled together in response to one common signal $\bar{E}$. Thus, when outputs $O_1$—$O_4$ from two of those chips are wire-ORed together, it is impossible to pass input signals from one of those chips to output $O_1$ and at the same time pass input signals from the other chip to output $O_2$.

Other examples of how any combination of the data input signals $i_0$—$i_{63}$ as well as their inverse and the internally generated "0" and "1" signals can be passed to conductors 51 and 52, are indicated in the remaining rows of Figure 5. Row 2, for example, indicates how inputs $i_{63}$ and $i_0$ are respectively passed to conductors 51 and 52; row 3 indicates how the inverse of $i_0$ and a "O" are respectively generated on conductors 51 and 52; and row 4 indicates how a "1" and the inverse of signal $i_0$ are respectively generated on conductors 51 and 52. In each case, outputs $O_1$ and $O_2$ from chips 1 and 2 are selectively disabled as indicated by the encircled "10Ø" values of signals $D_4$, $D_5$, $D_6$, where "Ø" means don't care.

Various preferred embodiments of the invention, as well as the features and advantages thereof, have now been described in detail. In addition, however, many changes and modifications can be made to these details without departing from the nature and the spirit of the invention. For example, it is to be understood that programmable memory 31 may be .constructed with a wide variety of technologies. For example, the fuses within memory 31 may be comprised of polysilicon and the memory address decoders and output drivers may be comprised of bipolar transistors such as those in the Intel 3628A 1K $\times$ 8 bipolar programmable memory chip.

As another alternative, memory 31 may be constructed as an ultraviolet erasable memory in which each fuse is replaced by a floating gate field-effect transistor. That is, this embodiment would include no fuses at all; but instead, the fuses previously discussed in conjunction with rows 2 and 3 of Figure 3 would be replaced by an equal number of floating gate field-effect transistors. In general, a bit in this type of memory is programmed to a "0" by selectively storing charge on the floating gate of the particular field-effect transistor corresponding to that bit; and the memory is programmed to all "1s" by radiating all of the floating gate field-effect transistors with ultraviolet light. This type of memory construction is utilized, for example, in the Intel 2716 programmable memory chip.

Accordingly, it is to be understood that the invention is not limited to said details but is defined by the appended claims.

### Claims

1. A programmable multiplexer circuit (41,42,43,44) comprising a multiplexer unit in turn comprising; a multiplexer (30) as coupled to receive a plurality of input signals $(i_0$—$i_{31},i_{32}$—$i_{63})$ and to receive a plurality of control signals $(D_0$—$D_6)$ and operable in response to receipt thereof to select one from among said plurality of input signals $(i_0$—$i_{31},i_{32}$—$i_{63})$ to be coupled as an output (OUTPUT) of said multiplexer (30); and a programmable read-only memory (31) coupled to receive as input a plurality of address signals $(A_0$—$A_4)$ and operable in response to receipt thereof to provide, as output, said plurality of control signals $(D_0$—$D_6)$ in accordance with a respective, predetermined programme stored therein; said multiplexer circuit being characterised by comprising a plurality of said multiplexer units (41,42,43,44); by each of said multiplexer units (41,42,43,44) comprising a logic circuit (32) coupled to receive one or more of said control inputs $(D_4,D_5,D_6)$ coupled to receive said output (OUTPUT) of said multiplexer (30), and operable in response thereto selectably to provide as output (32f) either a representation of said output (OUTPUT) of said multiplexer (30) or a high impedance tri-state output; by each of said plurality of multiplexer units (41,42,43,44) being coupled to receive said plurality of address signals $(A_0$—$A_4)$; by said plurality of multiplexer units (41,42,43,44) being arranged in one or more groups, each comprising two or more multiplexer units (41,42,43,44) where, in each group (41,43 and 42,44) said outputs of said logic circuits are wired in parallel; and by said respective predetermined programmes in said read-only memories (31) in each of said multiplexer units (41,42,43,44) being such that in each of said groups (41,43 or 42,44) at most only one of said multiplexer units (41,42,43,44) in said each group (41,43 or 42,44) has its respective logic circuit (32) not providing, as its output (32f), said high impedance tri-state output for each particular combination of said address signals $(A_0$—$A_4)$.

2. A multiplexer circuit (41,42,43,44) according to Claim 1, wherein said logic circuit (32) in said each of said multiplexer units (41,42,43,44) is further operable in response to receipt of said one or more $(D_4,D_5,D_6)$ of said plurality of control inputs $(D_0$—$D_6)$ to provide, as said output (on 32f) of said logic circuit (32) selectably either a pre-emptive logical one or a pre-emptive logical zero regardless of the logical state of said selected output (OUTPUT) of said multiplexer (30).

3. A multiplexer circuit (41,42,43,44) according to Claim 1 or Claim 2, wherein said programmable read-only memory (31) in said each of said plurality (41,42,43,44) of multiplexer units (as shown in Fig. 2) comprises an array of fuses, each selectably individually meltable for said array to be programmed to store said respective predetermined programme.

4. A multiplexer circuit (41,42,43,44) according to Claim 1 or Claim 2, wherein said programmable read-only memory (31) in each of said plurality (41,42,43,44) of multiplexer units (illustrated in Fig. 2) comprises an array of floating-gate field-effect transistor memory cells each individually programmable for storage of said respective predetermined programme.

5. A multiplexer circuit (41,42,43,44) according to Claim 1 or Claim 2, wherein said read-only memory (31) in said each of said plurality (41,42,43,44) of multiplexer units (illustrated in Fig. 2) comprises a plurality of bipolar transistor memory cells.

### Revendications

1. Circuit-multiplexeur programmable (41,42,43,44) comportant une unité de multiplexeur comprenant elle-même un multiplexeur (30) recevant un ensemble de signaux d'entrée $(i_0$—$i_{31},\ i_{32}$—$i_{63})$ et un ensemble de signaux de commande $(D_0$—$D_6)$ et travaillant en réponse à la réception de ceux-ci pour choisir l'un parmi un ensemble de signaux d'entrée $(i_0$—$i_{31},\ i_{32}$—$i_{63})$ pour être appliqué comme sortie (SORTIE) du multiplexeur (32) ainsi qu'une mémoire morte programmable (31) recevant comme entrée un ensemble de signaux d'adresses $(A_0$—$A_4)$ et travaillant en réponse à la réception de ceux-ci pour fournir en sortie cet ensemble de signaux de commande $(D_0$—$D_6)$ en fonction d'un programme prédéterminé respectif qui est enregistré; le circuit-multiplexeur étant caractérisé en ce qu'il comporte un ensemble d'unités de multiplexeur (41,42,43,44), chacune des unités de multiplexeur (41,42,43,44) comportant un circuit logique (32) recevant une ou plusieurs des unités de commande $(D_4,D_5,D_6)$ pour recevoir la sortie (SORTIE) du multiplexeur (30) et mise en oeuvre en réponse à celui-ci pour ·fournir sélectivement comme sortie (32f) soit une represésentation de la sortie (SORTIE) du multiplexeur (30) ou une sortie à trois états à impédance élevée; chacun des ensembles d'unités de multiplexeur (41,42,43,44) étant couplé de façon à recevoir cet ensemble de signaux d'adresses $(A_0$—$A_4)$, cet ensemble d'unités de multiplexeur (41,42,43,44) étant réparti en un ou plusieurs groupes, chacun comportant deux ou plusieurs unités de multiplexeur (41,42,43,44), et dans chaque groupe (41,43 ou 42,44), ces groupes de circuits logiques étant câblés en parallèle, ainsi que des programmes prédéterminés respectifs dans les mémoires mortes (31) de chacune des unités de multiplexeur (41,42,43,44) de façon telle que dans chacun des groupes (41,43 ou 42,44) pratiquement seulement l'une des unités de multiplexeur (41,42,43,44) de chaque groupe (41,43 ou 42,44) voit son circuit logique respectif (32) ne fournissant pas comme sortie (32f) la sortie à trois états d'impédance élevée pour chaque combinaison particulière des signaux d'adresses (A$_0$—A$_4$).

2. Circuit-multiplexeur (41,42,43,44) selon la revendication 1, caractérisé en ce que le circuit logique (32) de chacune des unités de multiplexeur (41,42,43,44) travaille en outre en réponse à la réception d'une ou plusieurs (D$_4$,D$_5$,D$_6$) des entrées de commande (D$_0$—D$_6$) pour fournir comme sortie (sur 32) du circuit logique (32) choisi, soit un état logique "1" pré-évacué, soit un état logique "0" pré-évacué quel que soit l'état logique de la sortie choisie (SORTIE) du multiplexeur (30).

3. Circuit-multiplexeur (41,42,43,44) selon la revendication 1 ou la revendication 2, caractérisé en ce que la mémoire morte programmable (31) de chacun des ensembles d'unités de multiplexeur (41,42,43,44) (comme représenté à la figure 2) se compose d'un réseau de fusibles, chacun pouvant fondre séparément pour programmer le réseau et enregistrer le programme prédéterminé.

4. Circuit-multiplexeur (41,42,43,44) selon la revendication 1 ou la revendication 2, caractérisé en ce que la mémoire morte programmable (31) de chacun des ensembles (41,42,43,44) d'unités de multiplexeur (représentés à la figure 2) se compose d'un réseau de cellules de mémoire à transistors à effet de champ à porte flottante, chacune des cellules étant programmable séparament pour stocker le programme prédéterminé respectif.

5. Circuit-multiplexeur (41,42,43,44) selon la revendication 1 ou la revendication 2, caractérisé en ce que la mémoire programmable (31) de chacun des ensembles (41,42,43,44) d'unités de multiplexeur (représentés à la figure 2) se compose d'un enxemble de cellules de mémoire à transistors bipolaires.

**Patentansprüche**

1. Programmierbare Multiplexerschaltung (41,42,43,44) mit einer Multiplexereinheit, die wiederum einen Multiplexer (30), der mehrere Eingangssignale (i$_0$—i$_{31}$, i$_{32}$—i$_{63}$) und mehrere Steuersignale (D$_0$—D$_6$) empfängt und auf deren Empfang eins unter den mehreren Eingangssignalen (i$_0$—i$_{31}$, i$_{32}$—i$_{63}$) als Ausgangssignal (OUTPUT) des Multiplexers (30) auswählt, und einen programmierbaren Festwertspeicher (31) enthält, an dessen Eingang mehrere Adressensignale (A$_0$—A$_4$) anstehen und der auf deren Empfang als Ausgangssignal die mehreren Steuersignale (D$_0$—D$_6$) entsprechend einem in ihm gespeicherten, vorbestimmten Programm abgibt, dadurch gekennzeichnet, daß die Multiplexerschaltung mehrere Multiplexereinheiten (41,42,43,44) enthält, daß jede der Multiplexereinheiten (41,42,43,44) eine logische Schaltung (32) aufweist, die eins oder mehrere der Steuereingangssignale (D$_4$,D$_5$,D$_6$) und das Ausgangssignal (OUTPUT) des Multiplexers (30) empfängt und darauf wahlweise als Ausgangssignal (32f) entweder eine Darstellung des Ausgangssignals (OUTPUT) des Multiplexers (30) oder einen Tristate-Ausgang hoher Impedanz abgibt; daß jede der mehreren Multiplexereinheiten (41,42,43,44) die mehreren Adressensignale (A$_0$—A$_4$) empfängt, daß die mehreren Multiplexereinheiten (41,42,43,44) in einer oder mehreren Gruppen angeordnet sind, von denen jede zwei oder mehr Multiplexereinheiten (41,42,43,44) enthält, wobei in jeder Gruppe (41,43 und 42,44) die Ausgänge der logischen Schaltungen parallel geschaltet sind; und daß die jeweils vorbestimmten Programme in den Festwertspeichern (31) jeder der Multiplexereinheiten (41,42,43,44) dergestalt sind, daß in jeder Gruppe (41,43 oder 42,44) die logische Schaltung (32) höchstens einer der Multiplexereinheiten (41,42,43,44) in jeder Gruppe (41,43 oder 42,44) als Ausgangssignal (32f) nicht das Tristate-Ausgangssignal hoher Impedanz für jede spezielle Kombination der Adressensignale (A$_0$—A$_4$) aufweist.

2. Multiplexerschaltung (41,42,43,44) nach Anspruch 1, dadurch gekennzeichnet, daß die logische Schaltung (32) in jeder der Multiplexereinheiten (41,42,43,44) auf den Empfang eines oder mehrerer (D$_4$,D$_5$,D$_6$) der mehreren Steuereingangssignale (D$_0$—D$_6$) als Ausgangssignal (auf 32f) der logischen Schaltung (32) wahlweise entweder eine frei vorgebbare logische Eins oder eine frei vorgebbare logische Null unabhängig vom logischen Zustand des ausgewählten Ausgangs (OUTPUT) des Multiplexers (30) abgibt.

3. Multiplexerschaltung (41,42,43,44) nach Anspruch 1 oder 2, dadurch gekennzeichnet, daß der programmierbare Festwertspeicher (31) in jeder der mehreren Multiplexereinheiten (41,42,43,44, wie in Fig. 2 dargestellt) eine Gruppe von Sicherungen enthält, von denen jede individuell schmelzbar ist, damit die Gruppe programmiert wird, um das entsprechende, vorbestimmte Programm zu speichern.

4. Multiplexerschaltung (41,42,43,44) nach Anspruch 1 oder 2, dadurch gekennzeichnet, daß der programmierbare Festwertspeicher (31) in jeder der mehreren Multiplexereinheiten (41,42,43,44, wie in Fig. 2 dargestellt) eine Gruppe von Feldeffekt-Transistor-Speicherzellen mit offenem Steueranschluß enthält, von denen jede individuell zum Speichern des vorbestimmten Programms programmierbar ist.

5. Multiplexerschaltung (41,42,43,44) nach Anspruch 1 oder 2, dadurch gekennzeichnet, daß der Festwertspeicher (31) in jeder der mehreren Multiplexereinheiten (41,42,43,44, dargestellt in Fig. 2) mehrere bipolare Transistor-Speicherzellen enthält.

# FIG. 1. Prior Art.

io

i1

i2

i3

i4

i5

i6

i7

i8

i9

20

15 10x8 FUSE ARRAY

16 10x8 FUSE ARRAY

17 10x8 FUSE ARRAY

18 10x8 FUSE ARRAY

8          8          8          8

S2

S1

So

11 8 x 1 MUX

12 8 x 1 MUX

13 8 x 1 MUX

14 8 x 1 MUX

$\overline{E}$

$0_1$          $0_2$          $0_3$          $0_4$

FIG.2.

$i_{31}$ • • • • • • • • • • • $i_2$  $i_1$  $i_0$

TO OTHER
FIXED MUX'S

DATA INPUTS

FIXED MUX ( 32 x 1 )

CONTROL
INPUTS

OUTPUT

30

PROM ( $32_w$ x $7_b$ )

OUTPUTS

$D_0$
$D_1$
$D_2$
$D_3$
$D_4$
$D_5$
$D_6$

31

ADDR.
INPUTS

TO OTHER
PROMS

$A_4$ • • • $A_0$

32a

32b

32c

32d

32e

32

32f

TO OTHER GATES 32d

0 081 917

2

## FIG.3.

| | DATA INPUTS PER CHIP | SELECTIONS PER OUTPUT | FUSES PER OUTPUT | OUTPUTS PER CHIP | TOTAL FUSES PER CHIP | SAVINGS |
|---|---|---|---|---|---|---|
| *Prior Art* ROW ONE ──►(FIG.1.) | 32 | 32 | 32×32 | 16 | 16,384 | ///// |
| EMBOD. OF ROW TWO.──►(FIG. 2.) | 32 | 32 | 32×5 | 16 | 2,560 | 14,124 |
| EMBOD. OF ROW THREE──►(FIG. 2.) | 32 | 32 | 32×7 | 16 | 3,584 | 12,800 |

## FIG.5.

| | 51 | 52 | 41 D4 D5 D6 | 42 D4 D5 D6 | 43 D4 D5 D6 | 44 D4 D5 D6 |
|---|---|---|---|---|---|---|
| ROW ONE ──► | · i0 | i63 | −10 | 100 | 100 | −10 |
| ROW TWO ──► | i63 | i0 | 100 | −10 | −10 | 100 |
| ROW THREE ──► | $\overline{i0}$ · | 0 | −11 | 000 | 100 | 100 |
| ROW FOUR ──► | 1 | $\overline{i0}$ | −001 | −11 | 100 | 100 |

0 081 917

# FIG.4.

CHIP 1.

$i_{31}$ ●●●●● $i_0$

41 42

$A_4$
|
$A_0$

$O_1$ $O_2$

51 52

CHIP 2.

$i_{63}$ ●●●●● $i_{32}$

43 44

$A_4$
|
$A_0$

$O_1$ $O_2$

51 52